(19) Europäisches Patentamt
European Patent Office
Office européen des brevets

(11) EP 2 172 988 A2

(12) **EUROPEAN PATENT APPLICATION**

(43) Date of publication:
**07.04.2010 Bulletin 2010/14**

(51) Int Cl.:
***H01L 51/44*** *(2006.01)*

(21) Application number: **09012455.3**

(22) Date of filing: **01.10.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **01.10.2008 JP 2008256237**

(71) Applicant: **Fujifilm Corporation**
**Tokyo 106-0031 (JP)**

(72) Inventor: **Tsukahara, Jiro**
**Ashigarakamai-gun**
**Kanagawa 258-8577 (JP)**

(74) Representative: **HOFFMANN EITLE**
**Patent- und Rechtsanwälte**
**Arabellastrasse 4**
**81925 München (DE)**

(54) **Organic solar cell device**

(57) An organic solar cell device comprising a substrate, a power-generating laminate and a barrier laminate provided on at least one side of the power-generating laminate, wherein the power-generating laminate comprises a pair of electrodes and an organic layer disposed between the electrodes, and the barrier laminate comprises at least one organic polymer layer and at least one inorganic layer, is flexible and highly-durable.

Fig.4

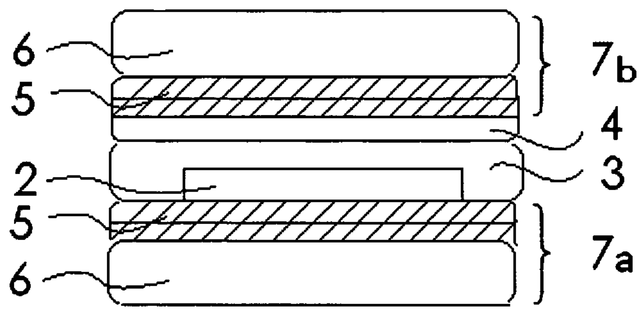


EP 2 172 988 A2

## Description

BACKGROUND OF THE INVENTION

FIELD OF THE INVENTION

The present invention relates to an organic solar cell device, precisely to an organic solar cell device protected with a barrier laminate.

BACKGROUND ART

As a convincing means for solving energy problems, various types of solar cells have been put into practical use. In particular, an organic solar cell device is specifically noted as a means for realizing lightweight, readily-portable and flexible solar cells (USP 4,281,053, Applied Physics Letters, Vol. 48, p. 183 (1986), Applied Physics Letters, Vol. 79, p. 126 (2001), Applied Physics Letters, Vol. 84, p. 4218 (2004) and Advanced Materials, Vol. 17, p. 66 (2005)).

However, in consideration of industrial applicability, these solar cells are poorly durable and are therefore defective in that they do not bear long-term use. Accordingly, it is desired to develop an organic solar cell having high durability and bearing long-term use. Further, it is desired to develop a flexible and highly-durable organic solar cell.

SUMMARY OF THE INVENTION

Given the problems as above, the present inventors have assiduously studied and, as a result, have found that, when a barrier laminate comprising at least one organic polymer layer and at least one inorganic layer is disposed outside the electrode that constitutes an organic solar cell device, then it enhances the life of the organic solar cell device, and have completed the present invention. Concretely, the inventors have found that the above-mentioned problems can be solved by the following constitutions:

(1) An organic solar cell device comprising a substrate, a power-generating laminate and a barrier laminate provided on at least one side of the power-generating laminate, wherein the power-generating laminate comprises a pair of electrodes and an organic layer disposed between the electrodes, and the barrier laminate comprises at least one organic polymer layer and at least one inorganic layer.
(2) The organic solar cell device of (1), wherein the barrier laminate comprises at least two organic polymer layers and at least two inorganic layers.
(3) The organic solar cell device of (1) or (2), wherein the organic polymer layer of the barrier laminate comprises a (meth)acrylate polymer as a main ingredient thereof.
(4) The organic solar cell device of any one of (1) to (3), comprising a barrier laminate, a power-generating laminate and a barrier laminate layered in that order on a plastic film.
(5) The organic solar cell device of any one of (1) to (3), comprising a barrier laminate, a power-generating laminate, a barrier laminate and a plastic film layered in that order on a plastic film.
(6) The organic solar cell device of any one of (1) to (5), wherein a protective layer is disposed in at least one between the power-generating laminate and the barrier laminate.
(7) The organic solar cell device of any one of (1) to (6), wherein the power-generating laminate is covered with at least one of the barrier laminate and the protective layer.
(8) The organic solar cell device of any one of (1) to (7), wherein the inorganic layer of the barrier laminate comprises a silicon oxide, a silicon nitride, a silicon oxinitride, an aluminium oxide, an aluminium nitride or an aluminium oxinitride.

The invention has thus made it possible to provide an organic solar cell device of high durability. Further, the invention has made it possible to provide a flexible solar cell device.

BRIEF DESCRIPTION OF THE DRAWINGS

Fig. 1 shows a first example of the constitution of the organic solar cell device of the invention.
Fig. 2 shows a second example of the constitution of the organic solar cell device of the invention.
Fig. 3 shows a third example of the constitution of the organic solar cell device of the invention.
Fig. 4 shows a fourth example of the constitution of the organic solar cell device of the invention.

In these drawings, 1 is a glass substrate; 2 is a power-generating laminate; 3 is a protective layer; 4 is an adhesive layer; 5 is a barrier laminate; 6 is a plastic film; and 7, 7a and 7b each are a gas-barrier film.

DETAILED DESCRIPTION OF THE INVENTION

The contents of the invention are described in detail hereinunder. In this description, the numerical range expressed by the wording "a number to another number" means the range that falls between the former number indicating the lowermost limit of the range and the latter number indicating the uppermost limit thereof. The term "organic solar cell device" as used herein means a photoelectric transducer capable of converting light energy into electric energy, in which the power-generating laminate comprises at least one organic layer. In this description, (meth) acrylate is meant to indicate both acrylate and methacrylate.

The organic solar cell device of the invention comprises a substrate, a power-generating laminate and a barrier laminate provided on at least one side of the power-generating laminate. In this, the power-generating laminate comprises a pair of electrodes and an organic layer disposed between the electrodes. The barrier laminate comprises at least one organic polymer layer and at least one inorganic layer.

In case where gas-barrier glass, metal or the like is used for the substrate of the organic solar cell device of the invention, a barrier laminate is unnecessary on the substrate side of the power-generating laminate and therefore, the device may have a constitution of substrate/power-generating laminate/barrier laminate. However, the solar cell device of the type may be poorly flexible.

In case where the substrate is a plastic film, preferably, the device has a constitution of substrate/barrier laminate/power-generating laminate/barrier laminate, or a constitution of barrier laminate/substrate/power-generating laminate/barrier laminate.

Needless-to-say, the device may have any additional substrate or optional functional layer in addition to the above-mentioned constitution. In particular, preferred is a constitution having a protective layer between the power-generating laminate and the barrier laminate. Another preferred example is a constitution having an adhesive layer between the power-generating laminate and the barrier laminate.

In case where the organic solar cell device of the invention has a protective layer, it may have a constitution of glass substrate/power-generating laminate/protective layer/barrier laminate, a constitution of plastic film/barrier laminate/power-generating laminate/protective layer/barrier laminate, or a constitution of plastic film/barrier laminate/power-generating laminate/protective layer/adhesive layer/barrier laminate. The device of the invention may additionally have a glass substrate or a plastic film as the outermost layer thereof.

The organic solar cell device of the invention may be produced, for example, by preparing a glass substrate having thereon a transparent electroconductive layer serving as a positive electrode, then disposing an organic layer and a negative electrode on the substrate, and further disposing a protective layer and a barrier laminate in that order on it. Alternatively, a plastic film with a barrier laminate disposed thereon (hereinafter this may be referred to as "gas-barrier film") is previously prepared, and this may be stuck to the protective layer via an adhesive layer. In this case, the device has a constitution of glass substrate/power-generating laminate/protective layer/adhesive layer/barrier laminate/plastic film.

The adhesive for the adhesive layer may be a thermosetting adhesive, a UV-curable adhesive, etc. The curing condition and others for the adhesive may be suitably determined depending on the type of the adhesive, etc., for which, for example, referred to is the description in Adhesive Data Book, 2nd Ed. by the Adhesive Society of Japan, Nikkan Kogyo Simbun.

The organic solar cell device of the invention may be produced by preparing a gas-barrier film having thereon a transparent electroconductive layer serving as a positive layer, and laminating an organic layer, a negative electrode, a protective layer and a gas-barrier laminate in that order on it. Similarly to the above, the device may be produced to have a constitution of plastic film/barrier laminate/power-generating laminate/protective layer/adhesive layer/barrier laminate/plastic film. According to a production method similar to the above, the device may be produced to have a constitution of plastic film/barrier laminate/power-generating laminate/protective layer/adhesive layer/stainless thin film.

Examples of the constitution of the organic solar cell device of the invention are described below with reference to the drawings attached hereto. Needless-to-say, the constitution of the organic solar cell device of the invention is not limited to these examples.

Fig. 1 shows a first example of the constitution of the organic solar cell device of the invention, in which a power-generating laminate 2 is provided on a glass substrate 1, a protective layer 3 is provided to cover the power-generating laminate, and a barrier laminate 5 is provided to cover the protective layer. As illustrated, the power-generating laminate is covered with the barrier laminate and is therefore more effectively protected from external water invasion thereon.

Fig. 2 shows a second example of the constitution of the organic solar cell device of the invention, in which a power-generating laminate 2 is provided on a glass substrate 1, a protective layer 3 is provided to cover the power-generating laminate, and a gas-barrier film 7 is provided on the surface of the protective layer via an adhesive layer 4.

Fig. 3 shows a third example of the constitution of the organic solar cell device of the invention, in which a power-generating laminate 2 is provided on a gas-barrier film 7, a protective layer 3 is provided to cover the power-generating laminate, and a barrier laminate 5 is provided on the surface of the protective layer. The advantage of the organic solar cell device of this type is that the device is flexible.
Fig. 4 shows a fourth example of the constitution of the organic solar cell device of the invention, in which a power-generating laminate 2 is provided on a gas-barrier film 7a, a protective layer 3 is provided to cover the power-generating laminate, and a gas-barrier film 7b is provided on the surface of the protective layer via an adhesive layer 4.
The substrate for use in the organic solar cell device of the invention includes glass, plastic films, metal plates, etc. For making the device flexible, the substrate is especially preferably a plastic film.

<Plastic Film>

Not specifically defined in point of the material and the thickness thereof, the plastic film for use in the organic solar cell device of the invention may be any one capable of supporting the laminate of an organic polymer layer, an inorganic layer, etc., and may be suitably selected depending on the use and the object thereof. Concretely usable are thermoplastic resins such as polyester resin, methacrylic resin, methacrylic acid-maleic acid copolymer, polystyrene resin, transparent fluororesin, polyimide, fluoropolyimide resin, polyamide resin, polyamidimide resin, polyetherimide resin, cellulose acylate resin, polyurethane resin, polyether-ether-ketone resin, polycarbonate resin, alicyclic polyolefin resin, polyarylate resin, polyether-sulfone resin, polysulfone resin, cycloolefin copolymer, fluorene ring-modified polycarbonate resin, alicyclic-modified polycarbonate resin, fluorene ring-modified polyester resin, acryloyl compound, etc.
Preferably, the plastic film is formed of a heat-resistant material. Concretely preferred is a heat-resistant and transparent material having a glass transition temperature (Tg) of not lower than 100°C and/or a linear thermal expansion coefficient of not higher than 40 ppm/°C. Tg and the linear expansion coefficient of the material may be controlled by additives thereto, etc. The thermoplastic resin of the type includes, for example, polyethylene naphthalate (PEN: 120°C), polycarbonate (PC: 140°C), alicyclic polyolefin (for example, Nippon Zeon's Zeonoa 1600: 160°C), polyarylate (PAr: 210°C), polyether-sulfone (PES: 220°C), polysulfone (PSF: 190°C), cycloolefin copolymer (COC: compound in JP-A 2001-150584: 162°C), fluorene ring-modified polycarbonate (BCF-PC: compound in JP-A 2000-227603: 225°C), alicyclic-modified polycarbonate (IP-PC: compound in JP-A 2000-227603: 205°C), acryloyl compound (compound in JP-A 2002-80616: 300°C or higher), polyimide, etc. (The parenthesized data are Tg.) In case where the device is required to be transparent, alicyclic polyolefin and the like are preferred.
The plastic film for use in the organic solar cell device of the invention is generally required to be transparent, and its light transmittance is generally at least 80%, preferably at least 85%, more preferably at least 90%. The light transmittance may be determined as follows: According to the method of JIS-K7105, or that is, using an integrating sphere-type light transmittance meter, a sample film is analyzed for the whole light transmittance and the amount of scattering light, and the diffused transmittance is subtracted from the whole light transmittance.
Not specifically defined, the thickness of the plastic film is typically from 1 to 800 μm, preferably from 10 to 200 μm. Preferably, the plastic film has a barrier layer of a barrier laminate. The barrier laminate preferred for use in the invention is described below. The plastic film may have any additional functional layer of a transparent electroconductive layer, a primer layer, etc.
In case where a plastic film is disposed also on the outermost surface of the opposite side of the organic solar cell device of the invention, it is preferably the above-mentioned plastic film.

<Power-Generating Laminate>

The power-generating laminate in the invention is described in detail. The power-generating laminate comprises a pair of electrodes and an organic layer disposed between the electrodes. In this, the pair of electrodes is a positive electrode and a negative electrode. In view of the properties of the solar cell, at least one of the pair of electrodes is preferably transparent. The function of the organic layer is to absorb light and to generate an electron and a hole. A most simple power-generating laminate has a constitution of positive electrode/organic layer/negative electrode, in which the organic layer is a mixed layer of a hole-transporting material and an electron-transporting material. In some cases, however, the conversion efficiency in this constitution could not always be high. A constitution of positive electrode/hole-transporting layer/electron-transporting layer/negative electrode could overcome the drawback. A constitution of positive electrode/hole-transporting layer/mixed layer/electron-transporting layer/negative electrode could further enhance the conversion efficiency.
Between the positive electrode and the hole-transporting layer, or between the negative electrode and the electron-transporting layer, the laminate may have an auxiliary layer such as a charge blocking layer, a charge injection layer, etc. Each layer may comprise plural secondary layers. The organic solar cell device of the invention may have a tandem structure comprising plural combinations of hole-transporting layer/electron-transporting layer. Such a tandem-structured device is especially preferred as realizing a high open circuit voltage and a high conversion efficiency. In this case, a recombination layer is disposed as an interlayer. One specific example of the tandem-structure device has a constitution of positive electrode/hole-transporting layer/electron-transporting layer/recombination layer/hole-transporting layer/electron-transporting layer/negative electrode.

The device of the invention may have any other layer, if desired. The constitutive layers of the device may be favorably formed in any method of a dry film formation method such as a vapor deposition method or a sputtering method, or a transfer method, a printing method, etc.

The positive electrode, the negative electrode, the organic layer (hole-transporting layer, electron-transporting layer, etc.) and other layers that are the constitutive elements of the power-generating laminate are described below.

(Positive Electrode)

Not specifically defined in point of the shape, the structure and the size thereof, the positive electrode may be any one generally having the function of an electrode of receiving a hole from a hole-transporting layer, and it may be suitably selected from known electrode materials. As mentioned in the above, the positive electrode is generally provided as a transparent positive electrode.

As the material of the positive electrode, for example, preferred are metals, alloys, metal oxides, electroconductive compounds and their mixtures. Specific examples of the positive electrode material include electroconductive metal oxides such as antimony or fluorine-doped tin oxide (ATO, FTO), tin oxide, zinc oxide, indium oxide, indium tin oxide (ITO), indium zinc oxide (IZO), etc.; metals such as gold, silver, chromium, nickel, etc.; mixtures and laminates of those metals and electroconductive metal oxides; inorganic electroconductive substances such as copper iodide, copper sulfide, etc.; organic electroconductive materials such as polyaniline, polythiophene, polypyrrole, etc.; laminates thereof with ITO, etc. Of those, preferred are electroconductive metal oxides; and more preferred are ITO, ATO, FTO and IZO from the viewpoint of the producibility, the electroconductivity and the transparency thereof.

The positive electrode may be formed on the above-mentioned substrate according to a method suitably selected from a wet method such as a printing method, a coating method, etc., a physical method such as a vacuum evaporation method, a sputtering method, an ion-plating method. etc., or a chemical method such as CVD, plasma CVD, etc., in consideration of the aptitude thereof for the material to constitute the positive electrode. For example, in case where ITO is selected as the material for the positive electrode, the positive electrode may be formed according to a direct-current or high-frequency sputtering method, a vacuum evaporation method, an ion-plating method or the like.

In the organic solar cell device of the invention, the position in which the positive electrode is to be formed is not specifically defined, and the position for the positive electrode in the device may be suitably selected depending on the use and the object of the device. Preferably, the positive electrode is formed on the substrate of the device. In this case, the positive electrode may be formed entirely or partly on one surface of the substrate. The patterning in formation of the positive electrode may be attained through chemical etching in a mode of photolithography or the like, or through physical etching with laser or the like, or through vapor deposition or sputtering via a mask. If desired, a lift-off method or a printing method may also be employed for the positive electrode patterning. The thickness of the positive electrode may be suitably determined depending on the material to constitute the positive electrode, and therefore could not be indiscriminately defined. In general, the thickness may be from 10 nm to 50 $\mu$m or so, preferably from 50 nm to 20 $\mu$m.

The resistivity of the positive electrode is preferably at most 100 $\Omega$/square, more preferably at most 20 $\Omega$/square. For the purpose of reducing the resistivity thereof, a metal mesh may be applied to the positive electrode according to a mask vapor deposition method or the like. In case where the positive electrode is transparent, it may be colorless transparent or may be colored and transparent. In case where the light emission from the device is through the transparent positive electrode side, the transmittance of the transparent positive electrode is preferably at least 60 %, more preferably at least 70 %. A transparent positive electrode is described in detail in Yutaka Toyoda's " New Development of Transparent Electrode Film" published by CMC (1999), and the matters described in this may apply to the invention. In case where a plastic substrate having poor heat resistance is used, preferred is a transparent positive electrode formed of ITO or IZO at a low temperature not higher than 150°C.

(Negative Electrode)

Not specifically defined in point of the shape, the structure and the size thereof, the negative electrode may be any one generally having the function of an electrode of receiving an electron from an electron-transporting layer, and it may be suitably selected from known electrode materials depending on the use and the object of the organic solar cell device. As the material to constitute the negative electrode, for example, there are mentioned metals, alloys, metal oxides, electroconductive compounds and their mixtures. Specific examples of the negative electrode material include alkali metals (e.g., Li, Na, K, Cs, etc.), alkaline earth metals (e.g., Mg, Ca, etc.), gold, silver, lead, aluminium, sodium-potassium alloy, lithium-aluminium alloy, magnesium-silver alloy, indium, ytterbium and other rare earth metals. One of

these may be used alone; however, for satisfying both the stability and the electron injectability of the electrode, two or more of these may be used as combined.

Of those, preferred is a material containing silver, magnesium-silver alloy or aluminium as the main ingredient thereof. The material mainly comprising aluminium includes aluminium alone, and an alloy or mixture of aluminium with from 0.01 to 10% by mass of an alkali metal or alkaline earth metal (e.g., lithium-aluminium alloy, magnesium-aluminium alloy, etc.).

Not specifically defined, the negative electrode may be formed in any known method. For example, the negative electrode may be formed according to a method suitably selected from a wet method such as a printing method, a coating method, etc., a physical method such as a vacuum evaporation method, a sputtering method, an ion-plating method. etc., or a chemical method such as CVD, plasma CVD, etc., in consideration of the aptitude thereof for the material to constitute the negative electrode. For example, in case where metals are selected as the material for the negative electrode, one or more metals may be sputtered simultaneously or successively to form the negative electrode. The patterning in formation of the negative electrode may be attained through chemical etching in a mode of photolithography or the like, or through physical etching with laser or the like, or through vapor deposition or sputtering via a mask. If desired, a lift-off method or a printing method may also be employed for the positive electrode patterning.

In the device of the invention, the position in which the negative electrode is to be formed is not specifically defined. The negative electrode may be formed entirely or partly on the organic compound layer in the device. If desired, a dielectric layer of an alkali metal or alkaline earth metal fluoride, oxide or the like, having a thickness of from 0.1 to 5 nm, may be disposed between the negative electrode and the organic compound layer. The dielectric layer may be considered as a type of an electron injection layer. The dielectric layer may be formed, for example, according to a vacuum evaporation method, a sputtering method, an ion-plating method, etc. The thickness of the negative electrode may be suitably determined depending on the material to constitute the negative electrode, and therefore could not be indiscriminately defined. In general, the thickness may be from 10 nm to 5 $\mu$m or so, preferably from 50 nm to 1 $\mu$m.

The negative material may be transparent or opaque. The transparent negative electrode may be formed of a thin film of a negative electrode material having a thickness of from 1 to 10 nm as laminated with a transparent electroconductive material such as ITO, IZO, etc.

(Hole-Transporting Layer)

The hole-transporting layer is a layer having the function of receiving and transporting a hole to the positive electrode or the positive electrode side. The hole-transporting layer may be a single layer or a laminate layer of plural layers. At least one layer of the hole-transporting layer preferably has the capability of charge generation of absorbing light to generate an electron and a hole. The hole-transporting layer comprises one or more hole-transporting materials. Concretely, the hole-transporting material includes carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amine-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidene compounds, porphyrin compounds, phthalocyanine compounds, polythiophene derivatives, polypyrrole derivatives, polyparaphenylenevinylene derivatives, etc. The material of the hole-transporting layer having the capability of charge generation includes porphyrin compounds, phthalocyanine compounds, polythiophene derivatives, polypyrrole derivatives, polyparaphenylenevinylene derivatives.

The thickness of the hole-transporting layer is preferably from 1 nm to 100 nm, more preferably from 2 nm to 60 nm, even more preferably from 3 nm to 30 nm. The thickness of the hole injection layer is preferably from 0.1 nm to 200 nm, more preferably from 0.5 nm to 100 nm, even more preferably from 1 nm to 100 nm. The hole injection layer and the hole-transporting layer may have a single-layer structure of one or more of the above-mentioned materials, or may have a multilayer structure of plural layers of the same or different compositions.

(Electron-Transporting Layer)

The electron-transporting layer is a layer having the function of transporting an electron to the negative electrode or the negative electrode side. The electron-transporting layer may be a single layer or a laminate layer of plural layers. At least one layer of the electron-transporting layer preferably has the capability of charge generation of absorbing light to generate a charge. The electron-transporting layer comprises one or more electron-transporting materials. Concretely, the electron-transporting material includes fullerene derivatives, paraphenylenevinylene derivatives, triazole derivatives, oxazole derivatives, oxadiazole derivatives, phenanthroline derivatives, imidazole derivatives, fluorenone derivatives, anthraquinonedimethane derivatives, anthrone derivatives, diphenylquinone derivatives, thiopyran dioxide derivatives, carbodiimide derivatives, fluorenylidenemethane derivatives, distyrylpyrazine derivatives, aromatic tetracarboxylic acid derivatives such as naphthalene, perylene, etc., and imides and heterocyclic compounds derived from these; various

metal complexes such as typically 8-quinolinol derivative metal complexes, benzoxazole or benzothiazole ligand-having metal complexes; organic silane derivatives, etc. The material of the electron-transporting layer having the capability of charge generation includes fullerenes, polyparaphenylenevinylene derivatives, and imides and heterocyclic compounds derived from perylenetetracarboxylic acid anhydrides.

The thickness of the electron-transporting layer is preferably from 1 nm to 100 nm, more preferably from 2 nm to 60 nm, even more preferably from 3 nm to 30 nm. The electron-transporting layer may have a single-layer structure of one or more of the above-mentioned materials, or may have a multilayer structure of plural layers of the same or different compositions. A hole blocking layer of Bathocuproin or the like may be provided between the electron-transporting layer and the negative electrode.

(Mixed Layer)

Preferably, a mixed layer containing both a hole-transporting material and an electron-transporting material is disposed between the hole-transporting layer and the electron-transporting layer as an interlayer therebetween for enhancing the conversion efficiency in the organic solar cell device. For forming the mixed layer, generally employed is a co-deposition method of vacuum evaporation. The blend ratio is controlled so as to enhance the conversion ratio, and is generally selected from the range of 20/80 to 80/20 by mass.

(Recombination Layer)

In a tandem device, plural groups of hole-transporting layer/electron-transporting layers are connected in series, and therefore a recombination layer is provided therein. As the material for the recombination layer, used is an ultra-thin layer of an electroconductive material. Preferred metals include gold, silver, aluminium, platinum, ruthenium oxide, etc. Of those, more preferred is silver. The thickness of the recombination layer may be from 0.01 to 5 nm, preferably from 0.1 to 1 nm, more preferably from 0.2 to 0.6 nm. Not specifically defined, the recombination layer may be formed in any known method. For example, it may be formed according to a vacuum evaporation method, a sputtering method, an ion-plating method, etc.

<Protective Layer>

In the device of the invention, the power-generating layer may be protected with a protective layer. The material for the protective layer includes metal oxides such as MgO, SiO, $SiO_2$, $Al_2O_3$, $Y_2O_3$, $TiO_2$, etc.; metal nitrides such as $SiN_x$, etc.; metal oxinitrides such as $SiN_xO_y$, etc.; metal fluorides such as $MgF_2$, LiF, $AlF_3$, $CaF_2$, etc.; polymers such as polyethylene, polypropylene, polyvinylidene fluoride, polyparaxylylene, etc. Of those, preferred are metal oxides, nitrides, oxinitrides; and more preferred are silicon or aluminium oxide, nitride and oxinitride. The protective layer may be a single layer or a multilayer.

Not specifically defined, the protective layer may be formed in any known method of, for example, a vacuum evaporation method, a sputtering method, a reactive sputtering method, an MBE (molecular beam epitaxial) method, a cluster ion beam method, an ion-plating method, a plasma polymerization method (high-frequency exited ion-plating method), a plasma CVD method, a laser CVD method, a thermal CVD method, a gas source CVD method, a vacuum UV-CVD method, a coating method, a printing method, a transfer method. In the invention, the protective layer may serve also as an electroconductive layer.

<Barrier Laminate>

The barrier laminate in the invention comprises at least one organic polymer layer and at least one inorganic layer. Preferably, the barrier laminate in the invention has a structure of alternate lamination of at least two organic polymer layers and at least two inorganic layers.

(Organic Polymer Layer)

The organic polymer layer in the invention is concretely a layer of a thermoplastic resin such as polyester, acrylic resin, methacrylic resin, methacrylic acid-maleic acid copolymer, polystyrene, transparent fluororesin, polyimide, fluoropolyimide, polyamide, polyamidimide, polyetherimide, cellulose acylate, polyurethane, polyether-ether-ketone, polycarbonate, alicyclic polyolefin, polyarylate, polyether-sulfone, polysulfone, fluorene ring-modified polycarbonate, alicyclic-modified polycarbonate, fluorene ring-modified polyester, acryloyl compound, etc., or a layer of polysiloxane or other organic silicon compound (silicon carbide, silicon oxicarbide or the like formed through CVD using an organic silane gas as the starting material). The polymer layer may be formed of a single material or a mixture. The polymer

layer may be a laminate of two or more organic polymer sublayers. In this case, the constitutive layers may have the same or different compositions. As in US Laid-Open 2004-46497, employable is a layer of which the composition continuously changes in the thickness direction with no definite interface to the adjacent inorganic layer.

The organic polymer layer is preferably a (meth) acrylate polymer layer. The (meth)acrylate polymer is a polymer to be obtained through polymerization of a polymerizing composition that comprises a (meth) acrylate monomer as the main ingredient thereof.

In the polymerizing composition comprising a (meth) acrylate monomer as the main ingredient thereof preferred for use in the invention, the (meth) acrylate monomer may be a single compound or a mixture of two or more different types of monomer compounds. The molecular weight of the (meth) acrylate monomer is preferably from 200 to 2000, more preferably from 400 to 1000.

Specific examples of (meth)acrylate monomers are shown below, to which, however, the invention should not be limited.

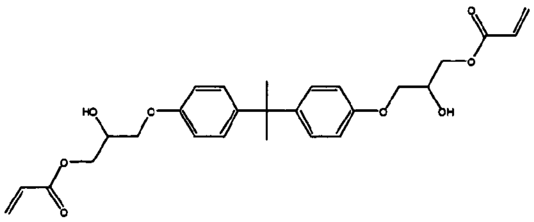

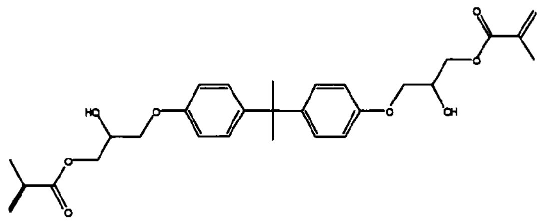

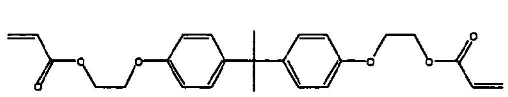

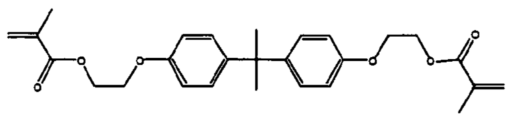

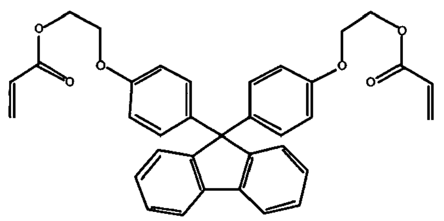

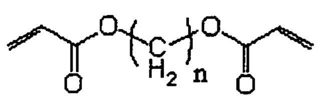

n=4,6,9,10,12,14,16

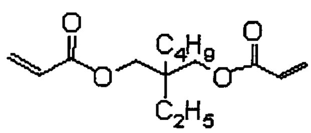

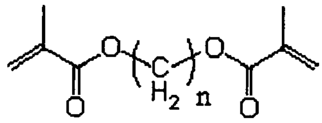

n=4,6,9,10,12,14,16

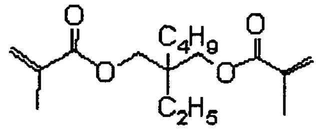

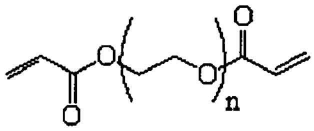

n=2,3,4,5

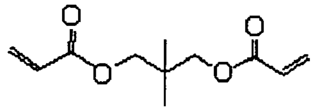

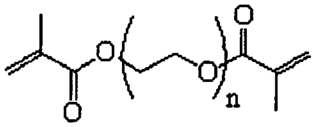

n=2,3,4,5

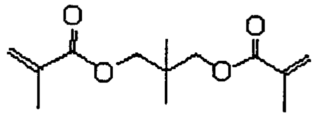

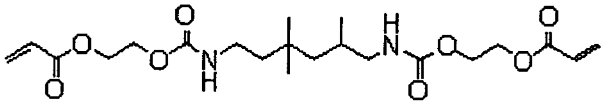

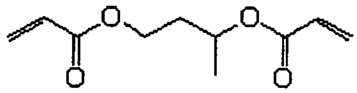

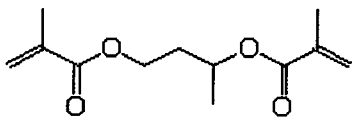

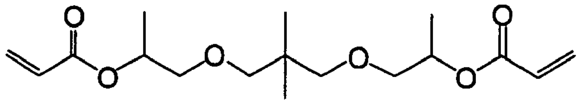

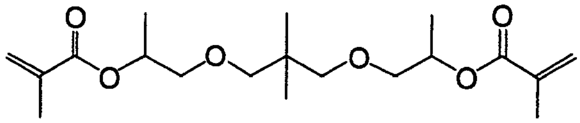

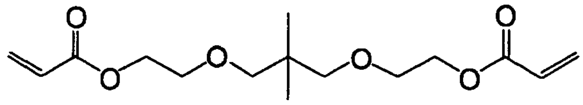

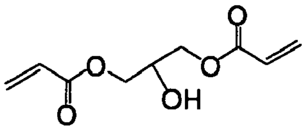

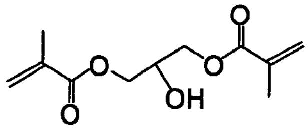

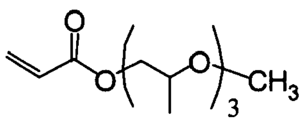

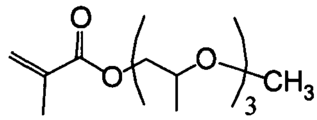

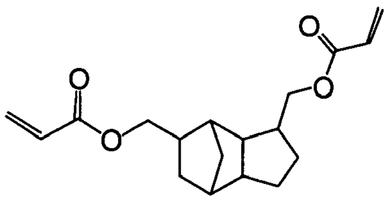

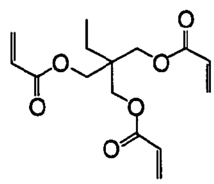

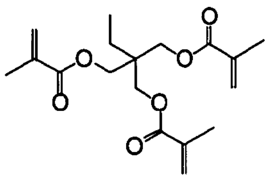

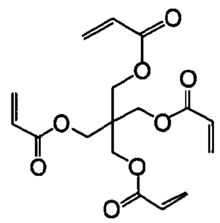

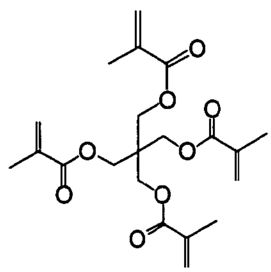

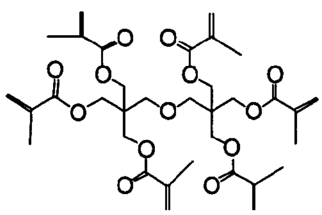

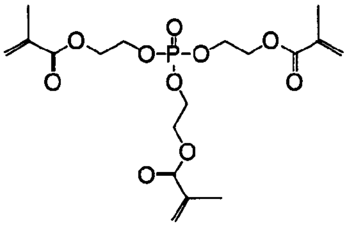

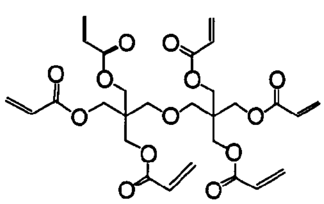

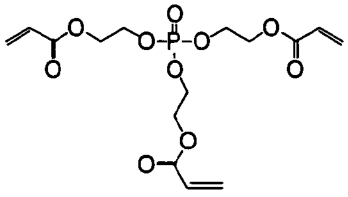
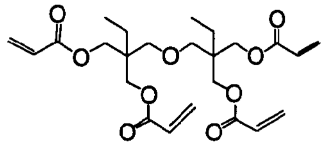
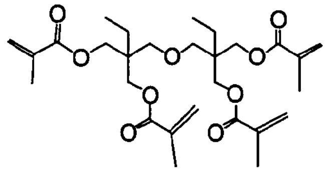

(Acidic Monomer)

The polymerizing composition for use in the invention may contain an acidic monomer. Containing an acidic monomer, the interlayer adhesiveness of the polymer layer may increase. The acidic monomer means a monomer having an acidic group, such as carboxylic acid, sulfonic acid, phosphoric acid, phosphonic acid, etc. The acidic monomer for use in the invention is preferably a monomer having a carboxylic acid group or a phosphoric acid group, more preferably a (meth) acrylate having a carboxylic acid group or a phosphoric acid group, even more preferably a phosphate group-having (meth)acrylate.

Preferred examples of acidic monomers for use in the invention are mentioned below, to which, however, the invention should not be limited.

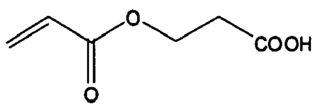
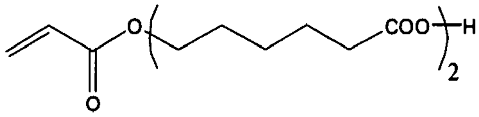

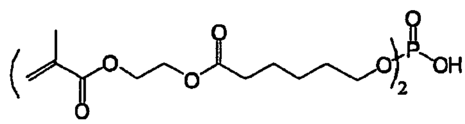
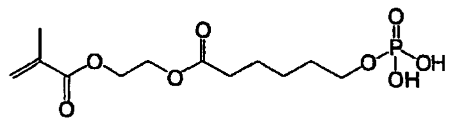

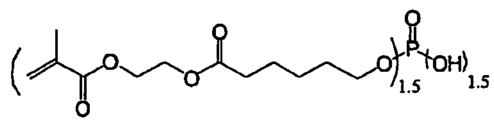
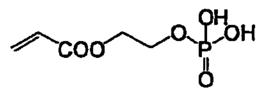

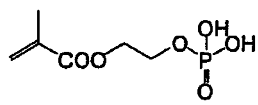

(Other Monomers, Polymer)

The polymerizing composition containing a (meth) acrylate monomer as a main ingredient for use in the invention may contain monomers other than (meth)acrylate (for example, styrene derivative, maleic anhydride derivative, epoxy compound, oxetane derivative) and various polymers (for example, polyester, methacrylic acid-maleic acid copolymer, polystyrene, transparent fluoro-resin, polyimide, fluorinated polyimide, polyamide, polyamide imide, polyether imide, cellulose acylate, polyurethane, polyether ketone, polycarbonate, alicyclic polyolefin, polyarylate, polyether sulfone, polysulfone, fluorene modified polycarbonate, alicyclic modified polycarbonate, fluorene modified polyester).

(Polymerization Initiator)

The polymerizing composition containing a (meth) acrylate monomer as a main ingredient for use in the invention may contain a polymerization initiator. When a photopolymerization initiator is used, its amount is preferably at least 0.1 mol% of the total amount of the polymerizable compound, more preferably from 0.5 to 2 mol%. By setting the thus-designed composition, polymerization reaction though an active ingredient forming reaction may be suitably controlled. Examples of the photopolymerization initiator include Ciba Speciality Chemicals' commercial products, Irgacure series (e.g., Irgacure 651, Irgacure 754, Irgacure 184, Irgacure 2959, Irgacure 907, Irgacure 369, Irgacure 379, Irgacure 819), Darocure series (e.g., Darocure TPO, Darocure 1173), Quantacure PDO; Lamberti's commercial products, Ezacure series (e.g., Ezacure TZM, Ezacure TZT, Ezacure KTO46) and oligomer-type Esacure KIP series, etc.

(Thickness of Organic Polymer Layer)

Not specifically defined, the thickness of the organic polymer layer is generally within a range of from 100 to 5000 nm/layer, preferably within a range of from 200 to 2000 nm/layer. Two or more organic polymer sublayers may be laminated. In this case, the constitutive layers may have the same composition or may have different compositions.

(Method of formation of organic polymer layer)

The method for forming the organic polymer layer is not specifically defined. For example, the layer may be formed according to a solution coating method and a vacuum film formation method. The solution coating method is, for example, a dipping method, an air knife coating method, a curtain coating method, a roller coating method, a wire bar coating method, a gravure coating method, a slide coating method, or an extrusion coating method using a hopper as in USP 2681294. The vacuum film formation method is not specifically defined, but is preferably a film formation method by vapor deposition or plasma CVD. In the invention, the polymer may be applied for coating as its solution, or a hybrid coating method along with an inorganic material, as in JP-A 2000-323273 and 2004-25732, may also be used.

In the invention, the polymerizable composition is exposed to light for curing, and the light for exposure is generally a UV ray from a high-pressure mercury lamp or low-pressure mercury lamp. The radiation energy is preferably at least 0.1 $J/cm^2$, more preferably at least 0. 5 $J/cm^2$. Acrylate and methacrylate may suffer from interference in polymerization owing to oxygen in air, and therefore, in their polymerization, the oxygen concentration or the oxygen partial pressure is preferably lowered. When the oxygen concentration in polymerization is lowered according to a nitrogen purging method, the oxygen concentration is preferably at most 2%, more preferably at most 0.5%. When the oxygen partial pressure in polymerization is lowered by a pressure reduction method, the whole pressure is preferably at most 1000 Pa, more preferably at most 100 Pa. Especially preferred is UV polymerization with at least 0.5 $J/cm^2$ energy radiation under a condition of reduced pressure of at most 100 Pa.

(Inorganic Layer)

Not specifically defined, the inorganic layer may be any one having a gas-barrier property and composed of an inorganic substance. Examples of the components include metal oxides, metal nitrides, metal carbides, metal oxinitrides and metal oxicabides. Preferred are oxides, nitrides, carbides, oxinitrides or oxicarbides comprising at least one metal selected from Si, Al, In, Sn, Zn, Ti, Cu, Ce and Ta. Of those, preferred are oxides, nitrides or oxinitrides of a metal selected from Si, Al, In, Sn, Zn and Ti; more preferred are metal oxides, nitrides or oxinitrides with Si or Al. These may be pure substances or may be mixtures or graded material layers of plural compositions. Mixtures of such preferred inorganic substances are also preferred.

The inorganic layer may be formed in any method capable of forming the intended thin film. For the formation, for example, preferred are a sol-gel method, a sputtering method, a vacuum evaporation method, an ion-plating method, a plasma CVD method, etc. Concretely, the formation methods described in Japanese Patent No. 3400324, JP-A 2002-322561, 2002-361774 may be employed. In particular, when a film of a silicon compound is formed, preferably employed is any of an inductively coupled plasma CVD film formation method, or an electric field-imparted plasma PVD or CVD film formation method with microwaves set under electron cyclotron resonance conditions; and most preferably employed is an inductively coupled plasma CVD film formation method. Inductively coupled plasma CVD or electric field-imparted plasma CVD with microwaves set under electron cyclotron resonance conditions (ECR-CVD) may be attained, for example, according to the methods described in CVD Handbook by the Chemical Engineering Society of Japan, p. 284 (1991). Electric field-imparted plasma PVD with microwaves set under electron cyclotron resonance conditions (ECR-PVD) may be attained, for example, according to the methods described in Ono et al's Jpn. J. Appl. Phys. 23, No. 8, L534 (1984). The starting material in CVD includes a gas source of silane or the like, and a liquid source of hexamethyldisilazane or the like, as a silicon supply source.

Regarding the smoothness of the inorganic layer to be formed in the invention, the mean roughness (Ra value) of the layer in 1 μm square is preferably less than 1 nm, more preferably at most 0.5 nm. Accordingly, the inorganic layer is preferably formed in a clean room. The degree of cleanness is preferably on a level of at most class 10000, more preferably at most class 1000.

Not specifically defined, the thickness of the inorganic layer is generally within a range of from 5 to 500 nm/layer, preferably within a range of from 10 to 200 nm/layer. Two or more inorganic sublayers may be laminated. In this case, the constitutive layers may have the same composition or may have different compositions. The boundary between the organic polymer layer and the inorganic layer may be unclear and the composition may continuously change in the thickness direction as shown in US 2004/46497.

(Lamination of Organic Polymer Layer and Inorganic Layer)

The organic polymer layer and the inorganic layer may be laminated by repeated film formation to form the organic polymer layer and the inorganic layer in a desired layer constitution. When the inorganic layer is formed according to a vacuum film formation process such as sputtering process, vacuum evaporation process, ion plating process or plasma CVD, then it is desirable that the organic polymer layer is also formed according to a vacuum film formation process such as the above-mentioned flash vapor deposition process. While the barrier layer is formed, it is especially desirable that the organic polymer layer and the inorganic layer are laminated all the time in a vacuum of at most 1000 Pa, not restoring the pressure to an atmospheric pressure during the film formation. More preferably, the pressure is at most 100 Pa, even more preferably at most 50 Pa, still more preferably at most 20 Pa.

Particularly, the barrier laminate of the invention shows improved barrier property when it has an alternately laminated structure of at least two organic polymer layers and at least two inorganic layers. For example, an organic polymer layer, an inorganic layer, an organic polymer layer and an inorganic layer can be laminated on a substrate in this order; and an inorganic layer, an organic polymer layer, an inorganic layer and an organic polymer layer can be laminated on a substrate in this order.

<Functional Layer>

The organic solar cell device of the invention may have a functional layer on the barrier laminate or in any other position. The functional layer is described in detail in JP-A 2006-289627, paragraphs 0036 to 0038. Examples of other functional layers than those are a matting agent layer, a protective layer, a solvent-resistant layer, an antistatic layer, a smoothening layer, an adhesiveness improving layer, a light shielding layer, an antireflection layer, a hard coat layer, a stress relaxing layer, an antifogging layer, an anti-soiling layer, a printable layer, an adhesive layer, etc.

Preferably, the thickness of the organic solar cell device of the invention is from 50 μm to 1 mm, more preferably from 100 μm to 500 μm.

In case where a solar cell is constructed, using the organic solar cell device of the invention, referred to is the description in Yoshihiro Hamakawa's Sunlight Power Generation, Newest Technology and Systems, by CMC, etc.

EXAMPLES

The characteristics of the invention are described more concretely with reference to the following Examples. In the following Examples, the material used, its amount and the ratio, the details of the treatment and the treatment process may be suitably modified or changed. Accordingly, the invention should not be limitatively interpreted by the Examples mentioned below.

Formation of Gas-Barrier Film:

Formation of Gas-Barrier Film (1):

Using a wire bar, a composition comprising the polymerizing compounds mentioned below (14 parts by weight in total), a polymerization initiator (Ciba Speciality Chemicals, Irgacure 907, 1 part by weight) and 2-butanone (185 parts by weight) was applied onto a polyethylene naphthalate film (Teijin-DuPont's Teonex Q65FA, having a thickness of 100 μm), and cured through irradiation with UV at a dose of 0.5 $J/cm^2$ in an atmosphere of 100 ppm oxygen, thereby forming an organic polymer layer. The thickness of the organic polymer layer was 500 nm. Next, an $Al_2O_3$ layer having a thickness of 40 nm was formed on the surface of the organic polymer layer through vacuum sputtering (reactive sputtering), thereby producing a gas-barrier film.

Composition of Polymerizing Compounds:

The following compounds A to D were mixed in the ratio shown below.

Compound A: Kyoeisha Chemical's Light Acrylate 1,9-ND-A: 50% by mass

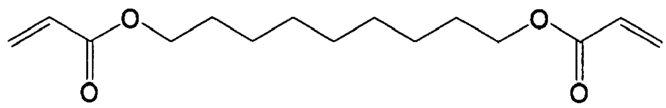

Compound B: Daicel-Cytec's TMPTA: 30% by mass

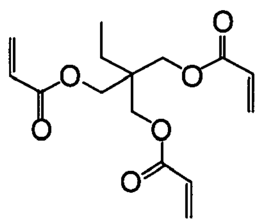

Compound C: Daicel-Cytec's IRR=214K: 10% by mass

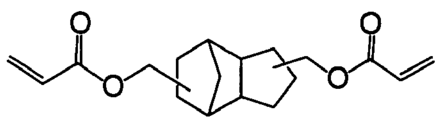

Compound D: Nippon Kayaku's Kayarad, PM-21: 10% by mass

Formation of Gas-Barrier Film 2:

In the same manner as above, one organic polymer layer and one inorganic layer were formed on the gas-barrier film (1). Accordingly, a gas-barrier film (2) was produced, alternately comprising two organic polymer layers and two inorganic layers.

Formation of Gas-Barrier Film (3):

Further in the same manner, one organic polymer layer and one inorganic layer were formed on the gas- barrier film (2). Accordingly, a gas-barrier film (3) was produced, alternately comprising three organic polymer layers and three inorganic layers.

Formation of Gas-Barrier Films (4) and (5):

Gas-barrier films (4) and (5) were produced in the same manner as in the production of the gas-barrier film (3), for which, however, $Al_2O_3$ in the inorganic layer was changed to $SiO_2$ and $Si_3N_4$, respectively.

Formation of Comparative Gas-Barrier Film:

A comparative gas-barrier film was produced in the same manner as in the production of the gas-barrier film (1), in which, however, the organic polymer layer was not formed and which therefore had one organic layer alone.

Determination of Water Vapor Permeability:

Thus produced, the gas-barrier films were tested for the barrier property (water vapor permeability) according to the method mentioned below.

[Barrier Property]

According to the method described in SID Conference Record of the International Display Research Conference 1435-1438 (by G. NISATO, P.C.P. BOUTEN, P.J. SLIKKERVEER, et al.) (so-called calcium method), the films were analyzed for the water vapor permeability (g/m$^2$/day) thereof. In the test method, the temperature was 40°C and the relative humidity was 90%.

Table 1

| | Number of Organic Polymer Layers | Material of Inorganic Layer | Number of Inorganic Layers | Water Vapor Permeability (g/m$^2$/day) |
|---|---|---|---|---|
| Gas-Barrier Film (1) | 1 | $Al_2O_3$ | 1 | 0.0004 |
| Gas-Barrier Film (2) | 2 | $Al_2O_3$ $Al_2O_3$ | 2 | at most 0.0001 |
| Gas-Barrier Film (3) | 3 | $Al_2O_3$ $Al_2O_3$ | 3 | at most 0.0001 |
| Gas-Barrier Film (4) | 3 | $SiO_2$ $SiO_2$ | 3 | at most 0.0001 |
| Gas-Barrier Film (5) | 3 | $Si_3N_4$ $Si_3N_4$ | 3 | at most 0.0001 |
| Comparative Gas-Barrier Film | none | $Al_2O_3$ | 1 | 0.03 |

The above Table confirms that the gas-barrier films (1) to (5) all have a good gas-barrier property. In particular, the gas-barrier films (2) to (5) have a water vapor permeability of at most 0.0001, therefore having an extremely good gas-barrier property.

<Example 1>

Production of Organic Solar Cell Device:

According to the process mentioned below, an organic solar cell device having the constitution of Fig. 2 was produced. First, an electroconductive glass substrate having an ITO film (surface resistivity, 10 Ω/square) was washed with 2-propanol, and then processed with UV-ozone for 10 minutes. The following compound layers were formed successively by vapor deposition on the substrate (positive electrode).

(First Layer)

Copper phthalocyanine: thickness 10 nm

(Second Layer)

Co-deposition layer of copper phthalocyanine and fullerene $C_{60}$ (Aldrich's produced purified through sublimation): thickness 15 nm

(Third Layer)

Fullerene $C_{60}$: thickness 5 nm

(Fourth Layer)

PTCBI mentioned below (by Dainichi Seika Kogyo): thickness 5 nm

PTCBI

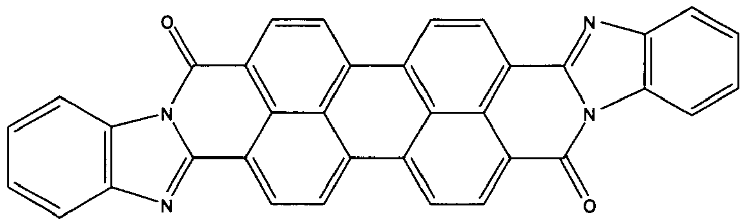

(Fifth Layer)

Silver: thickness 0.5 nm

(Sixth Layer)

Copper phthalocyanine: thickness 5 nm

(Seventh Layer)

Co-deposition layer of copper phthalocyanine and fullerene $C_{60}$: thickness 15 nm

(Eighth Layer)

Fullerene $C_{60}$: thickness 20 nm

(Ninth Layer)

Bathocuproin: thickness 8 nm

Silver 100 nm was vapor-deposited on the multilayer to from a negative electrode thereon, thereby producing a power-generating laminate.

A silicon nitride layer having a thickness of 0.2 μm and a silicon oxide layer having a thickness of 0.4 μm were alternately formed thereon to be 6 layers in all as a protective layer, according to a parallel-plate CVD method. Accordingly, an organic solar cell device having a protective layer was produced.

Next, using a thermosetting adhesive (Epotec 310, by Daizo-Nichimori), the thus-produced, organic solar cell device and one of the above-mentioned gas-barrier films (1) to (5) were stuck together in such a manner that the gas-barrier layer side could face the organic solar cell device, and the adhesive was cured by heating at 65°C for 3 hours. In that manner, organic solar cell devices (1) to (5) each sealed with a gas-barrier film were produced. Thus produced, the effective region of the solar cell device was 5 mm square and the effective area thereof was 0.25 $cm^2$.

Irradiated with artificial sunlight of AM 1.5 and 100 $mW/cm^2$, the thus-produced organic solar cell devices were tested for the current-voltage characteristics thereof, using a source measure unit (SMU2400 Model, by Keithley). The test data are shown in Table 2. In this, FF means a fill factor which is nondimensional.

Table 2

| Sample No. | Sealing Material | Open Circuit Voltage (V) | Short-Circuit Current Density ($mA/cm^2$) | FF | Conversion Efficiency (%) |
|---|---|---|---|---|---|
| Organic Solar Cell Device (1) of the Invention | Gas-Barrier Film (1) | 0.95 | 6.5 | 0.55 | 3.4 |
| Organic Solar Cell Device (2) of the Invention | Gas-Barrier Film (2) | 0.96 | 6.4 | 0.54 | 3.3 |
| Organic Solar Cell Device (3) of the Invention | Gas-Barrier Film (3) | 0.98 | 6.6 | 0.55 | 3.6 |
| Organic Solar Cell Device (4) of the Invention | Gas-Barrier Film (4) | 0.96 | 6.3 | 0.53 | 3.2 |
| Organic Solar Cell Device (5) of the Invention | Gas-Barrier Film (5) | 0.97 | 6.4 | 0.52 | 3.2 |
| Organic Solar Cell Device (6) of Comparative Example | Comparative Gas-Barrier Film | 0.97 | 6.2 | 0.51 | 3.1 |

The devices were kept in a high-temperature high-humidity room at 60°C and at a relative humidity of 90% for 100 hours, and then, while irradiated with artificial sunlight of AM 1.5 and 100 $mW/cm^2$, the devices were again tested for the current-voltage characteristics thereof. From the found data, the conversion efficiency retention was computed. The test results are shown in Table 3.

Conversion Efficiency Retention (%) = [(Conversion Efficiency after kept under high temperature and high humidity)/(Conversion Efficiency just after device production)] × 100

Table 3

| Sample No. | Conversion after device production (%) | Conversion Efficiency after Efficiency after kept under high temperature and high humidity (%) | Conversion Efficiency Retention (%) |
|---|---|---|---|
| Organic Solar Cell Device (1) of the Invention | 3.4 | 3.0 | 88 |
| Organic Solar Cell Device (2) of the Invention | 3.3 | 3.2 | 97 |
| Organic Solar Cell Device (3) of the Invention | 3.6 | 3.5 | 97 |
| Organic Solar Cell Device (4) of the Invention | 3.2 | 3.1 | 97 |
| Organic Solar Cell Device (5) of the Invention | 3.2 | 3.2 | 100 |
| Organic Solar Cell Device (6) of Comparative Example | 3.1 | 1.2 | 39 |

It is known that the organic solar cell devices of the invention all secure a high conversion efficiency retention after kept under high temperature and high humidity and therefore have high durability. In particular, it is known that the durability of the organic solar cell devices (2) to (5) having a barrier laminate of at least two organic polymer layers and at least two inorganic layers is especially high.

<Example 2>

Production of Flexible Organic Solar Cell Device (embodiment of Fig. 3):

The gas-barrier film (3) produced in the above was used as a substrate. On the gas-barrier film (3) serving as a substrate, an ITO film having a thickness of 200 nm formed according to a magnetron sputtering method. The obtained flexible ITO substrate was washed with 2-propanol and then processed with UV-ozone for 10 minutes. The following compound layers were formed successively by vapor deposition on the substrate (positive electrode).

(First Layer)

Copper phthalocyanine: thickness 10 nm

(Second Layer)

Co-deposition layer of copper phthalocyanine and fullerene $C_{60}$: thickness 15 nm

(Third Layer)

Fullerene $C_{60}$: thickness 5 nm

(Fourth Layer)

PTCBI: thickness 5 nm

(Fifth Layer)

Silver: thickness 0.5 nm

(Sixth Layer)

Copper phthalocyanine: thickness 5 nm

(Seventh Layer)

Co-deposition layer of copper phthalocyanine and fullerene $C_{60}$: thickness 15 nm

(Eighth Layer)

Fullerene $C_{60}$: thickness 20 nm

(Ninth Layer)

Bathocuproin: thickness 8 nm

Silver 100 nm was vapor-deposited on the multilayer to from a negative electrode thereon; and a silicon nitride layer having a thickness of 0.2 μm and a silicon oxide layer having a thickness of 0.4 μm were alternately formed thereon to be 6 layers in all as a protective layer, according to a parallel-plate CVD method.

On this, an organic polymer layer was formed, using an organic/inorganic laminate film formation apparatus (Vitex Systems' Guardian 200). The organic polymer formation method with the apparatus is a flash vapor deposition under an internal pressure of 3 Pa, and the UV irradiation energy dose for polymerization is 1.0 $J/cm^2$. As the material for the organic polymer layer, used was a mixture liquid of Compound B (30 g), Compound C (70 g) and a UV polymerization initiator (Esacure-TZT, 5 g). The thickness of the thus-formed organic polymer layer was 600 nm.

Next, also using Guardian 200, an aluminium oxide film was formed on the above, according to a reactive sputtering method with aluminium as a target (where the reactive gas was oxygen). Thus formed the inorganic layer (aluminium oxide layer) had a thickness of 40 nm. Similarly to the above-mentioned process and using Guardian 200, three organic layers and three inorganic layers were alternately formed to be an alternate barrier laminate, and the organic solar cell device was thereby sealed with the alternate barrier laminate.

Thus produced, the effective region of the solar cell device was 5 mm square and the effective area thereof was 0.25 $cm^2$.

The organic solar cell device thus produced herein was tested in the same manner as in Example 1, and the conversion efficiency retention thereof at 60°C and a relative humidity of 90% for 100 hours was computed. The conversion efficiency retention of the device was 96 %.

The above result confirms that the flexible organic solar cell device of this Example not having a glass substrate had good durability.

<Example 3>

Production of Flexible Organic Solar Cell Device (embodiment of Fig. 4):

An organic solar cell device was produced in the same manner as in Example 2, in which, however, a gas-barrier film (3) was disposed using an adhesive in the same manner as in Example 1 in place of providing the barrier laminate after formation of the protective layer. Thus produced, the organic solar cell device was tested for the conversion efficiency retention at 60°C and at a relative humidity of 90 % for 100 hours, in the same manner as in Example 1. The conversion efficiency retention of the device was 96 %.

The above result confirms that the organic solar cell device of this Example sealed with two gas-barrier films also had good durability.

INDUSTRIAL APPLICABILITY

The organic solar cell device of the invention is extremely meaningful in that it has high storage stability and therefore bears long-term use.

## Claims

1. An organic solar cell device comprising a substrate, a power-generating laminate and a barrier laminate provided on at least one side of the power-generating laminate, wherein the power-generating laminate comprises a pair of electrodes and an organic layer disposed between the electrodes, and the barrier laminate comprises at least one organic polymer layer and at least one inorganic layer.

2. The organic solar cell device according to Claim 1, wherein the barrier laminate comprises at least two organic polymer layers and at least two inorganic layers.

3. The organic solar cell device according to Claim 1 or 2, wherein the organic polymer layer of the barrier laminate comprises a (meth)acrylate polymer as a main ingredient thereof.

4. The organic solar cell device according to any one of Claims 1 to 3, comprising a barrier laminate, a power-generating laminate and a barrier laminate layered in that order on a plastic film.

5. The organic solar cell device according to any one of Claims 1 to 3, comprising a barrier laminate, a power-generating laminate, a barrier laminate and a plastic film layered in that order on a plastic film.

6. The organic solar cell device according to any one of Claims 1 to 5, wherein a protective layer is disposed in at least one between the power-generating laminate and the barrier laminate.

7. The organic solar cell device according to any one of Claims 1 to 6, wherein the power-generating laminate is covered with at least one of the barrier laminate and the protective layer.

8. The organic solar cell device according to any one of Claims 1 to 7, wherein the inorganic layer of the barrier laminate comprises a silicon oxide, a silicon nitride, a silicon oxinitride, an aluminium oxide, an aluminium nitride or an aluminium oxinitride.

Fig.1

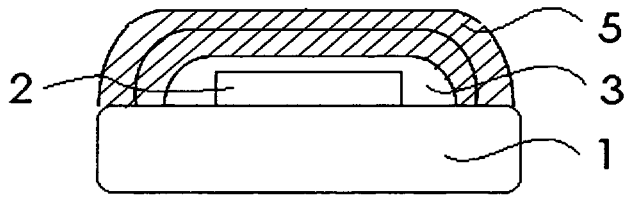


Fig.2

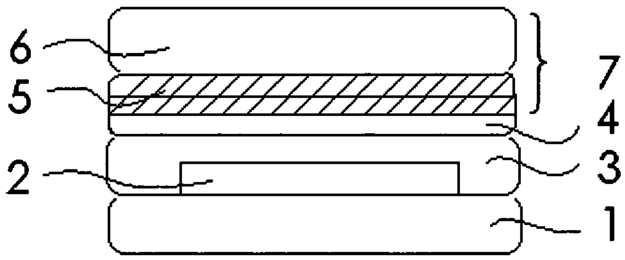


Fig.3

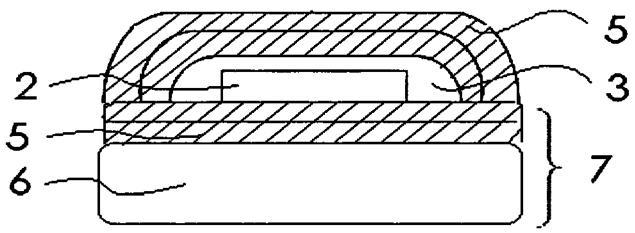


Fig.4

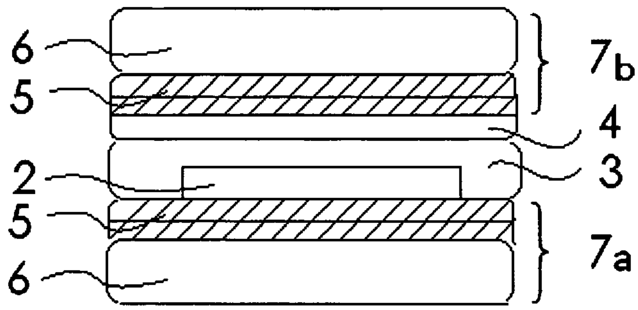

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*


### Patent documents cited in the description

- US P4281053 A
- JP 2001150584 A
- JP 2000227603 A
- JP 2002080616 A
- US 200446497 B
- US P2681294 A
- JP 2000323273 A
- JP 2004025732 A
- JP 3400324 B
- JP 2002322561 A
- JP 2002361774 A
- JP 2006289627 A

### Non-patent literature cited in the description

- *Applied Physics Letters,* 1986, vol. 48, 183
- *Applied Physics Letters,* 2001, vol. 79, 126
- *Applied Physics Letters,* 2004, vol. 84, 4218
- *Advanced Materials,* 2005, vol. 17, 66
- Adhesive Data Book. Nikkan Kogyo Simbun
- **Yutaka Toyoda's.** New Development of Transparent Electrode Film. CMC, 1999
- CVD Handbook. Chemical Engineering Society of Japan, 1991, 284
- **Ono et al.** *Jpn. J. Appl. Phys.,* 1984, vol. 23 (8), L534
- **G. NISATO ; P.C.P. BOUTEN ; P.J. SLIKKERVEER.** *SID Conference Record of the International Display Research Conference,* 1435-1438